# EUROPEAN PATENT SPECIFICATION

(11) **EP 3 719 856 B1**
(45) Date of publication and mention of the grant of the patent: **24.06.2026**
(21) Application number: 20159586.5
(22) Date of filing: 26.02.2020
(51) Int. Cl.: H10F 10/142, H10F 19/80

(54) **MULTIJUNCTION SOLAR CELL HAVING A FUSED SILICA COVER GLASS**
MEHRFACHÜBERGANGSSOLARZELLE MIT EINEM QUARZGLAS-DECKGLAS
CELLULE SOLAIRE À JONCTION MULTIPLE AYANT UN VERRE DE COUVERTURE EN SILICE FONDUE

(30) Priority: 01.04.2019 US 201916372114; 04.12.2019 US 201916702821
(43) Date of publication of application: 07.10.2020
(73) Proprietor: The Boeing Company, Arlington, VA 22202 (US)
(72) Inventor: REHDER, Eric M., CHICAGO, IL 60606-1596 (US); HO, Frank F., CHICAGO, IL 60606-1596 (US); SCHWARTZ, Joel A., CHICAGO, IL 60606-1596 (US)
(74) Representative: Boult Wade Tennant LLP

(56) References cited:
- EP-A1- 2 372 784
- US-A1- 2010 035 052
- US-A1- 2017 345 955
- CL�MENT LAUCHER ET AL: "Permanent bonding process for III-V/Ge multijunction solar cell integration", AIP CONFERENCE PROCEEDINGS, vol. 2012, 13 September 2018 (2018-09-13), NEW YORK, US, pages 090004-1 - 090004-6, XP055724140, ISSN: 0094-243X, DOI: 10.1063/1.5053542
- A V MASON ET AL: "Photovoltaic Manufacturing Technology Report, Phase 1", October 1992 (1992-10-01), pages 1 - 129, XP055724255, Retrieved from the Internet <URL:https://www.nrel.gov/docs/legosti/old/5019.pdf> [retrieved on 20200821]
- DATUM G C ET AL: "Gallium arsenide solar arrays - a mature technology", PROCEEDINGS OF THE PHOTOVOLTAIC SPECIALISTS CONFERENCE, OCT. 7 - 11, 1991, vol. CONF. 22, 7 October 1991 (1991-10-07), pages 1422 - 1428, XP010039143, ISBN: 978-0-87942-636-1, DOI: 10.1109/PVSC.1991.169440
- GAO XIN ET AL: "Effects of electron radiation on shielded space triple-junction GaAs solar cells", CHINESE PHYSICS B, vol. 18, no. 11, November 2009 (2009-11-01), pages 5015 - 5019, XP020169882, ISSN: 1674-1056
- JINGFENG YANG ET AL: "III-V on Silicon Multi-Junction Solar Cell with 25% 1-Sun Efficiency via Direct Metal Interconnect and Areal Current Matching", PROCEEDINGS OF THE 27TH EUROPEAN PHOTOVOLTAIC SOLAR ENERGY CONFERENCE, 24 September 2012 (2012-09-24) - 28 September 2012 (2012-09-28), pages 160 - 163, XP040633740, ISBN: 978-3-936338-28-7

## Description

### BACKGROUND

The present disclosure is related to a solar cell. Satellite missions are exposed to proton and electron radiation. For example, in a Medium Earth Orbit (MEO), there is a higher density of protons and electrons than at ground level, which leads to more rapid degradation of some components. To illustrate, solar cells used in satellites often have a borosilicate cover glass. In the MEO, the borosilicate cover glass darkens due to exposure to proton and electron radiation and, as a result, the solar cell (or solar array) has a reduced power output. Fused silica experiences less darkening due to proton and electron radiation than borosilicate glass materials. However, fused silica has a coefficient of thermal expansion that is significantly different than the coefficient of thermal expansion of Ge and compound semiconductor materials used to form space solar cells. Orbital solar cells can experience a very wide range of temperatures, such as between -170 deg. Centigrade (C) and 140 deg. C. As a result, differences in the coefficients of thermal expansion of materials used for a cover glass and materials used for a solar cell can be problematic.

US 2017/345955 A1, according to its abstract describes photovoltaic cells, methods for fabricating surface mount multijunction photovoltaic cells, methods for assembling solar panels, and solar panels comprising photovoltaic cells. The surface mount multijunction photovoltaic cells described include through-wafer-vias for interconnecting the front surface epitaxial layer to a contact pad on the back surface. The through-wafer-vias are formed using a wet etch process that removes semiconductor materials non-selectively without major differences in etch rates between heteroepitaxial III-V semiconductor layers.

In his article, Clement Laucher et al, "Permanent bonding process for III-V/Ge multijunction solar cell integration", AIP CONFERENCE PROCEEDINGS, NEW YORK, US, (20180913), vol. 2012, doi:10.1063/1.5053542, ISSN 0094-243X, pages 090004-1 - 090004-6, according to its abstract describes a process to permanently bond multi-junction solar cells (MJSCs) front side to a transparent superstrate using polydimethylsiloxane (PDMS). This process could allow for substrate handling during several fabrication schemes such as thin MJSCs, substrate lift-off /recycling or through cell via contacts (TCVC) solar cells. The developed process is compatible with standard microfabrication processes such as photolithography, etching or metallization. Permanent bonding of III-V/Ge triple junction solar cell on quartz superstrate has been used to handle the solar cell and to demonstrate a 20 µm thick TCVC device. No significant performance loss was observed on I-V characteristics for a bonded triple junction solar cell.

EP 2 372 784 A1, according to its abstract describes a solar cell. The solar cell comprises a first main surface and a second main surface opposite to the first main surface of a semiconductor body where a topmost pn-junction of an amount of pn-junctions stacked on top of each other adjoins to the first main surface. It furthermore describes a cell edge of the semiconductor body defining a shape of the first and the second main surfaces and thus the solar cell. An encapsulant is provided on the first main surface for providing an environmental protection of the semiconductor body. A mesa groove is provided on the first main surface and penetrates at least the topmost pn-junction. The mesa groove is located adjacent to the cell edge and is created around the circumference of the semiconductor body for providing an inner cell area and a mesa wall, the mesa wall being created between the mesa groove and the cell edge. The mesa groove is filled with the encapsulant.

US 2010/035052 A1, according to its abstract describes a polyimide substrates bonded to germanium wafers having an epitaxially grown III-V layer and a metal layer. The polyimide substrate and the Ge wafer are subsequently thinned by grinding and etching to reach a final thickness of 25 mums Ge on 25 mums adhesive layer on 50 mums polyimide substrate. There are several requirements for the adhesive layer to act as a permanent carrier of the thin fragile multijunction solar cell. The adhesive must remain flexible after curing and have a low CTE. It is desired to use an adhesive that cures without the addition of heat, preferably at room temperature. Furthermore, the adhesive layer should have a uniform thickness preferably less than 25 mums (1 mil) and be void-free. It is desired to use a clear adhesive which does not contain any particles in order to obtain a smooth uniform void-free bondline. A thin bonded wafer is demonstrated which has an epi-layer and a metal layer.

### SUMMARY

The present disclosure provides a method of fabricating a solar cell system as defined by independent claim 1. Preferred embodiments are defined in the appended dependent claims.

Implementations disclosed herein mitigate the effects of differences in the coefficients of thermal expansion of fused silica and materials of a solar cell. For example, according to a particular implementation, a solar cell can be formed in a manner that provides fewer crack initiation locations such that the solar cell is able to withstand higher levels of stress. To illustrate, a Germanium substrate on which a compound semiconductor material is deposited to form a multijunction solar cell can be diced with a diamond coated saw to provide a smooth edge that provides few crack initiation sites. As another illustrative example, backside grinding and etching can be used to reduce surface defects on the backside of the Germanium substrate. As another example, according to a particular implementation, the backside grinding and etching of the Germanium substrate can be configured to leave a relatively thick solar cell (as compared to prior solar cell). To illustrate, the Germanium portion of the solar cell can be more than 200 micrometers (µm) thick, which enables the solar cell to withstand higher levels of stress. As a further example, in some implementations, a fused silica cover glass can be attached to the solar cell using a silicone adhesive. Curing the silicone adhesive at temperatures within the use range reduces the thermal expansion stresses compared to more typical high temperature cures.

One advantage of the disclosed implementations is improved power output of a solar cell. For example, the fused silica cover glass is less subject to radiation darkening than borosilicate cover glass, which results in improved power output on orbit. In addition, a Germanium-backed multijunction solar cell has characteristics that reduce the likelihood of failure due to thermal expansion mismatch of the Germanium-backed multijunction solar cell and the fused silica cover glass. As non-limiting examples, the Germanium-backed multijunction solar cell has increased thickness providing greater protection against stress. Additionally, the backside grinding and etching of the Germanium-backed multijunction solar cell reduces backside surface roughness. For example, the backside etching and grinding can reduce a surface roughness metric of the Germanium-backed multijunction solar cell from ≥ 50 nanometers (nm) to ≤ 17 nm. Additionally, using a diamond saw to perform dicing operations reduces edge roughness of the Germanium-backed multijunction solar cell. Reduced surface roughness, edge roughness, or both, results in fewer sites for crack initiation. The features, functions, and advantages that have been described can be achieved independently in various implementations or may be combined in yet other implementations, further details of which are disclosed with reference to the following description and drawings.

### BRIEF DESCRIPTION OF THE DRAWINGS

FIG. 1A illustrates an example of a Germanium wafer used to fabricate a Germanium-backed multijunction solar cell having a fused silica cover glass.
FIG. 1B illustrates an example of performing a deposition operation on the Germanium wafer of FIG. 1A to deposit a compound semiconductor material and related circuitry.
FIG. 1C illustrates an example of performing a grinding operation on the Germanium wafer of FIG. 1B.
FIG. 1D illustrates an example of performing an etching operation on the Germanium wafer of FIG. 1C.
FIG. 1E illustrates an example of performing a dicing operation to cut the Germanium wafer of FIG. 1D into one or more Germanium-backed multijunction solar cells.
FIG. 1F illustrates an example of a packaging operation including coupling a fused silica cover glass to the multijunction solar cell.
FIG. 2 is a flowchart of a first example of a method of fabricating a Germanium-backed multijunction solar cell having a fused silica cover glass.
FIG. 3 is a flowchart of a second example of a method of fabricating a Germanium-backed multijunction solar cell having a fused silica cover glass.
FIG. 4 is a flowchart of a third example of a method of fabricating a Germanium-backed multijunction solar cell having a fused silica cover glass.
FIG. 5 is a flowchart of a fourth example of a method of fabricating a Germanium-backed multijunction solar cell having a fused silica cover glass.

### DETAILED DESCRIPTION

Particular embodiments of the present disclosure are described below with reference to the drawings. In the description, common features are designated by common reference numbers throughout the drawings.

The figures and the following description illustrate specific exemplary embodiments. It will be appreciated that those skilled in the art will be able to devise various arrangements that, although not explicitly described or shown herein, embody the principles described herein and are included within the scope of the claims that follow this description. Furthermore, any examples described herein are intended to aid in understanding the principles of the disclosure and are to be construed as being without limitation. As a result, this disclosure is not limited to the specific embodiments or examples described below, but by the claims and their equivalents.

As used herein, various terminology is used for the purpose of describing particular implementations only and is not intended to be limiting. For example, the singular forms "a," "an," and "the" are intended to include the plural forms as well, unless the context clearly indicates otherwise. Further, the terms "comprise," "comprises," and "comprising" are used interchangeably with "include," "includes," or "including." Additionally, the term "wherein" is used interchangeably with the term "where." As used herein, "exemplary" indicates an example, an implementation, and/or an aspect, and should not be construed as limiting or as indicating a preference or a preferred implementation. As used herein, an ordinal term (e.g., "first," "second," "third," etc.) used to modify an element, such as a structure, a component, an operation, etc., does not by itself indicate any priority or order of the element with respect to another element, but rather merely distinguishes the element from another element having a same name (but for use of the ordinal term). As used herein, the term "set" refers to a grouping of one or more elements, and the term "plurality" refers to multiple elements.

As used herein, "generating", "calculating", "using", "selecting", "accessing", and "determining" are interchangeable unless context indicates otherwise. For example, "generating", "calculating", or "determining" a parameter (or a signal) can refer to actively generating, calculating, or determining the parameter (or the signal) or can refer to using, selecting, or accessing the parameter (or signal) that is already generated, such as by another component or device. As used herein, "coupled" can include "communicatively coupled," "electrically coupled," or "physically coupled," and can also (or alternatively) include any combinations thereof. Two devices (or components) can be coupled (e.g., communicatively coupled, electrically coupled, or physically coupled) directly or indirectly via one or more other devices, components, wires, buses, networks (e.g., a wired network, a wireless network, or a combination thereof), etc. Two devices (or components) that are electrically coupled can be included in the same device or in different devices and can be connected via electronics, one or more connectors, or inductive coupling, as illustrative, non-limiting examples. In some implementations, two devices (or components) that are communicatively coupled, such as in electrical communication, can send and receive electrical signals (digital signals or analog signals) directly or indirectly, such as via one or more wires, buses, networks, etc. As used herein, "directly coupled" is used to describe two devices that are coupled (e.g., communicatively coupled, electrically coupled, or physically coupled) without intervening components.

The disclosed solar cell is designed and manufactured to provide improved power output especially in high radiation environments that would degrade borosilicate glass. For example, the disclosed solar cell uses a fused silica cover glass which is less subject to radiation darkening than borosilicate cover glass enabling greater light transmission to the solar cell which results in improved power output when used in the space environment. In addition, the solar cell is manufactured using one or more of a combination of manufacturing operations specifically designed to reduce the critical stress for crack propagation that is driven by the differences in the coefficient of thermal expansion of the fused silica cover glass and coefficients of thermal expansion of the Germanium substrate and of compound semiconductor materials of the solar cell. As non-limiting examples, the manufacturing operations used include one or more of: backside grinding and etching to reduce crack initiation sites on a backside of the Germanium substrate; backside grinding the Germanium substrate to a thickness greater than 150 µm (e.g., 200 µm or more); dicing using a diamond-coated saw to reduce crack initiation sites on edges of the Germanium substrate; or using relatively low temperatures to cure a silicone adhesive used to couple the fused silica cover glass to the solar cell. Individually, each of these manufacturing operations reduce the likelihood of having a crystalline defect that grows into a crack due to the differences in thermal expansion or improves tolerance to differential thermal expansion. Further, two or more of these manufacturing operations can be used in combination to achieve even greater improvements.

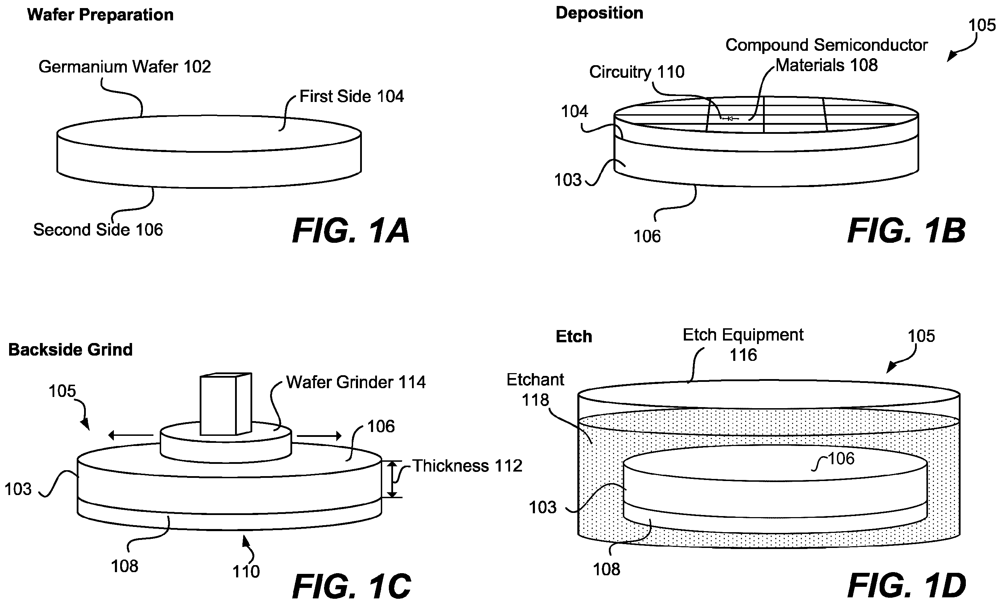

FIGS. 1A through 1F illustrate examples of various manufacturing process stages during fabrication of one or more Germanium-backed multijunction solar cell. In the following description, the manufacturing process stages of FIGS. 1A-1F are generally described as occurring sequentially; however, in other implementations, a Germanium-backed multijunction solar cell is manufactured using fewer operations, more operations, or different operations than described with reference to FIGS. 1A-1F.

FIG. 1A illustrates an example of a Germanium wafer 102 used to fabricate a Germanium-backed multijunction solar cell having a fused silica cover glass. In some implementations, the Germanium wafer 102 is purchased from a wafer supplier. In such implementations, the wafer supplier generally cuts (also referred to as wafer sawing) the Germanium wafer 102 from a large crystal of Germanium. The wafer supplier also prepares the Germanium wafer 102 for use in a semiconductor manufacturing process, which can include, for example, cleaning, planarizing, polishing, and indexing the Germanium wafer 102. The Germanium wafer 102 may undergo one or more additional preparatory operations after it is received from the wafer supplier, such as one or more cleaning or marking operations. In FIG. 1A, a first side 104 and a second side 106 of the Germanium wafer 102 are identified as references for subsequent manufacturing operations.

FIG. 1B illustrates an example of performing a deposition operation on the Germanium wafer 102 of FIG. 1A. In the example shown, the deposition operation deposits compound semiconductor materials 108 and related circuitry 110 on the first side 104 of the Germanium wafer 102, such that the Germanium wafer 102 corresponds to, includes, or is included within a Germanium layer 103 of an in-process wafer 105 after the deposition operation. The compound semiconductor materials 108 include two or more elements selected from Groups 13 through 15 of the periodic table (based on current International Union of Pure and Applied Chemistry (IUPAC) periodic table labeling conventions) and may also include other elements as dopants. The circuitry 110 includes device structures formed of the compound semiconductor materials 108 (e.g., transistors or diodes) and conductive traces between and among such device structures. In particular implementations, the circuitry 110 includes a metal, such as Aluminum, Copper, Silver, Gold, or combinations thereof.

In various implementations, the compound semiconductor materials 108 are deposited using metal organic vapor phase epitaxy (MOVPE), physical vapor deposition (PVD), chemical vapor deposition (CVD), plasma-enhanced CVD (PECVD), atomic layer deposition (ALD), evaporation, sputtering, molecular-beam epitaxy (MBE), or combinations thereof (e.g., ALD followed by CVD, etc.). Additionally, the deposition operation of FIG. 1B can include various patterning and cleaning operations to assist with depositing the compound semiconductor materials 108 in targeted locations. Further, additional materials can be deposited on the Germanium layer 103 or the compound semiconductor materials 108 during this manufacturing stage. To illustrate, oxide layers, nitride layers, or other barrier layers can be deposited or formed during this manufacturing stage.

The circuitry 110 is deposited using one or more of the deposition processes listed above, or using an electrochemical deposition process, such as plating. The deposition of the circuitry 110 can also include various patterning and cleaning operations to assist with depositing conductive materials in targeted locations.

FIG. 1C illustrates an example of performing a grinding operation (also referred to as a backside grinding operation) on the Germanium layer 103. In the example illustrated in FIG. 1C, a wafer grinder 114 performs the grinding operation on the second side 106 of the Germanium layer 103 to reduce a thickness 112 of the Germanium layer 103. The wafer grinder 114 uses physical abrasion to remove a portion of the Germanium layer 103. In some implementations, the grinding operation is performed in a single grind process. In other implementations, the grinding operation is performed in multiple stages, such as one or more coarse grinding operations followed by one or more fine grinding operations. The grinding operation reduces the thickness 112 of the Germanium layer 103 to a target thickness. In particular examples, the target thickness is greater than 150 µm, or even greater than 200 µm. To illustrate, in some implementation, the target thickness is approximately 205 µm. Leaving the Germanium layer 103 with a relatively large thickness 112 (e.g., greater than 150 µm) increases the strength of each solar cell formed from the Germanium layer 103 as compared to solar cells formed using thinner Germanium layers (e.g., solar cells formed on layers with thicknesses of about 140 µm or less.

Additionally, the grinding operation ends with a fine grind that smooths the second side 106 of the Germanium layer 103 to remove stress concentrators (e.g., cracks and scratches). In particular implementations, the Germanium layer 103 is subjected to an etching operation after the grinding operations, as illustrated in FIG. 1D. In the etching operation, the in-process wafer 105 is inserted into etch equipment 116, which exposes at least the second side 106 of the in-process wafer 105 to an etchant 118. In the particular example illustrated in FIG. 1D, the etching operations is a wet etch, which means the etch equipment 116 includes a liquid bath of the etchant 118 in which the in-process wafer 105 is wholly or partly submerged. Other implementations use a dry etch, such as a reactive ion etch. The etching operations further reduces the stress on the second side 106 by removing crystal defects induced in the crystal structure of the Germanium layer 103 by the grinding operation.

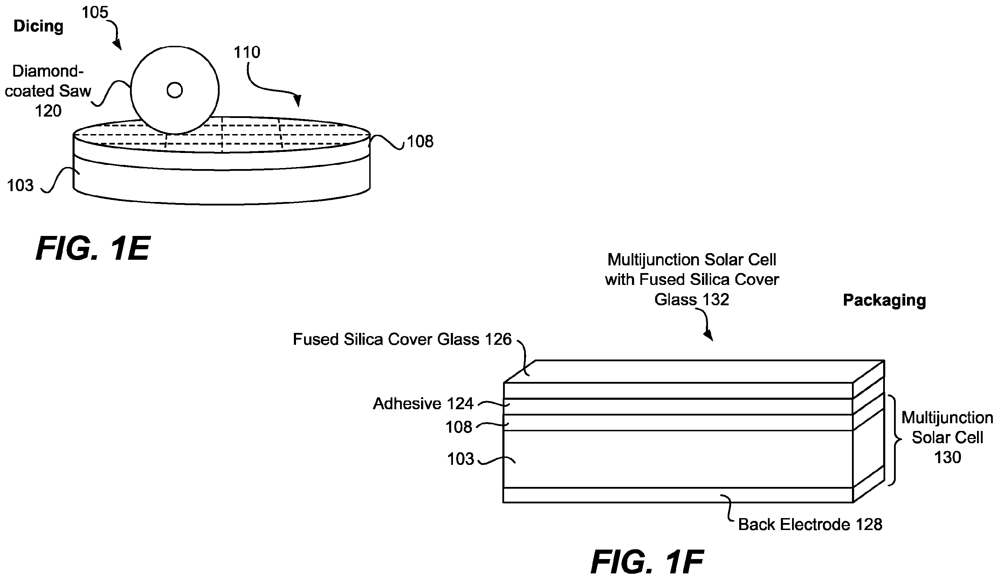

FIG. 1E illustrates an example of performing a dicing operation to cut the in-process wafer 105 (including the Germanium layer 103 of FIG. 1B) into one or more Germanium-backed multijunction solar cells. The dicing operation of FIG. 1E uses a diamond-coated saw 120 to cut the Germanium layer 103.

The diamond-coated saw 120 uses a very fine coating of diamond to abrade the in-process wafer 105, including the Germanium layer 103. Thus, in addition to cutting the Germanium layer 103 into various Germanium-backed multijunction solar cells, the diamond-coated saw 120 leaves a smoother edge to the Germanium-backed multijunction solar cell than a scribe and break based process. This smoother edge results in fewer stress concentrators and a higher fracture strength of each Germanium-backed multijunction solar cell.

FIG. 1F illustrates an example of a packaging operation including coupling a fused silica cover glass 126 to a multijunction solar cell 130 to form a Germanium-backed multijunction solar cell with a fused silica cover glass 132. The multijunction solar cell 130 corresponds to or includes a die cut from the in-process wafer 105 during the dicing operation of FIG. 1E. In some implementations, the multijunction solar cell 130 also includes back electrode 128 connected to the circuitry 110 by one or more connections (not shown). In such implementations, the back electrode 128 is formed using a deposition operation (e.g., evaporation), which can be performed on the in-process wafer 105 before performing the dicing operation or performed on individual die cut from the in-process wafer 105 after the dicing operation.

In the packaging operation illustrated in FIG. 1F, an adhesive 124 is applied to the first surface of the multijunction solar cell 130, where the first surface (corresponding to an upper surface in the orientation illustrated in FIG. 1F) of the multijunction solar cell 130. In an alternative implementation, the adhesive 124 is applied to a surface of the fused silica cover glass 126. In a particular implementation, the adhesive 124 is a silicone-based adhesive such as DOW CORNING^{®} 93-500 Space-Grade Encapsulant. After application of the adhesive 124, the fused silica cover glass 126 and the multijunction solar cell 130 are pressed together, and the adhesive 124 is cured. In some implementations, before curing, the adhesive 124 is a transparent, colorless, low viscosity fluid, and after curing, the adhesive 124 is a flexible solid that transmits light.

In a particular implementation, a low-temperature curing operation is used to cure the adhesive 124. For example, the adhesive 124 is cured at a temperature of less than 100 deg. C. Curing the adhesive 124 at a lower temperature (e.g., <100 deg. C) is generally slower than curing the adhesive 124 at a higher temperature (e.g., > 100 deg. C); however, it is believed that lower-temperature cured adhesive 124 reduces stress in the assembly.

As explained above, the operations illustrated in FIGS. 1A-1F are not intended to be comprehensive. For example, in some implementations, one or more protective layers (e.g., oxide layers or polymer layers) may be applied to overlie one or more surfaces of the Germanium layer 103, the compound semiconductor materials 108, the circuitry 110, or a combination thereof, before the grinding and etching operations are performed. In such implementations, the protective layer(s) can be removed before performing the packaging operations. As another example, in some implementations, the packaging operations further includes partially encapsulating the multijunction solar cell 130, such as applying a protective coating on edges of the multijunction solar cell 130.

Additionally, the order of the steps illustrated in FIGS. 1A-1F is different in some implementations. For example, in some implementations, a wafer level attach operation can be performed to couple a fused silica wafer to the in-process wafer 105. In this example, the dicing operation is performed to cut both the Germanium layer 103 and the attached fused silica wafer to form the multijunction solar cell with fused silica cover glass 132.

Additionally, in some implementations, one or more of the operations illustrated in FIGS. 1A-1F are performed in a different matter than describe above. To illustrate, in some implementations, the grinding operation is performed to a target thickness of less than 150 µm. In such implementations, the operations described with references to FIGS. 1B, 1D, 1E, and 1F are unchanged.

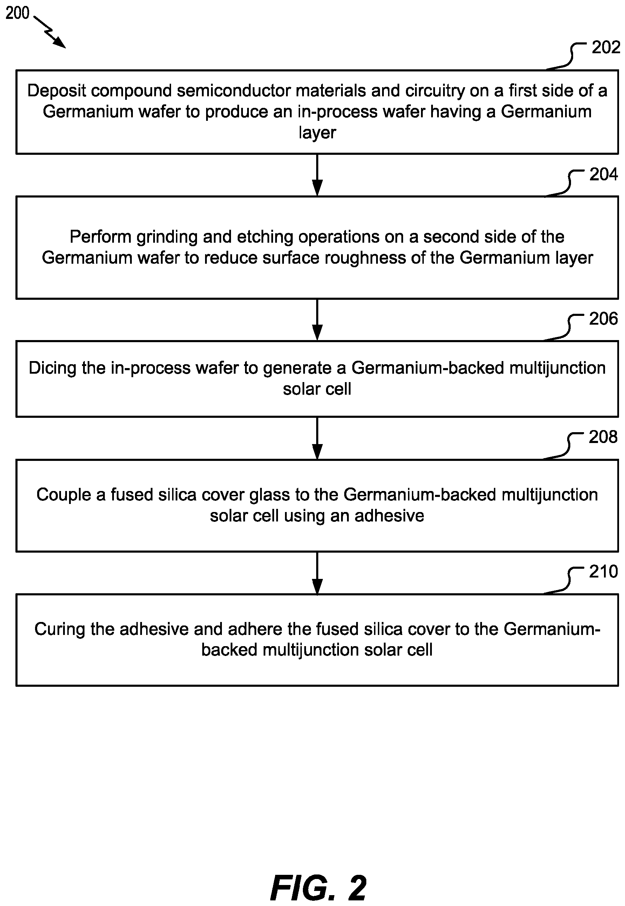

FIG. 2 is a flowchart of a first example of a method 200 of fabricating a multijunction solar cell 130 having a fused silica cover glass 126. The method 200 can be performed using the techniques described with respect to FIGS. 1A-1F.

The method 200 includes depositing compound semiconductor materials 108 and circuitry 110 on a first side of a Germanium wafer 102 to produce (e.g. to form) an in-process wafer 105 having a Germanium layer 103, at 202. For example, depositing the compound semiconductor materials 108 and circuitry 110 can be performed as described with reference to FIG. 1B.

The method 200 also includes performing grinding and etching operations on a second side 106 of a Germanium layer 103 to reduce surface roughness of the Germanium layer 103, at 204. In this context, the second side 106 of the Germanium layer 103 is opposite the first side 104 of the Germanium wafer 102. In some implementations, the grinding operation thins the Germanium layer 103 to a thickness greater than 150 µm or even greater than 200 µm, such as approximately 205 µm. For example, the grinding operation can be performed as described with reference to FIG. 1C. Reducing the surface roughness reduces the number and size stress concentrators on the second side 106 of the Germanium layer 103 by relieving crystal defects induced in the crystal structure of the Germanium layer 103 by the grinding operation.

The method 200 further includes dicing the in-process wafer 105 (including the Germanium layer 103) to generate a Germanium-backed multijunction solar cell 130, at 206. For example, the dicing operation can be performed as described with reference to FIG. 1E. In such implementations, the diamond-coated saw 120 cuts a narrow, smooth channel through the Germanium layer 103. As a result, relatively few, small defective regions are formed along cut edges of the Germanium layer 103 as compared to the number and size of defect regions formed using a scribe and break operation.

The method 200 also includes coupling a fused silica cover glass 126 to the Germanium-backed multijunction solar cell 130 using an adhesive, at 208. In some implementations, the adhesive is a silicone-based adhesive 124. The method 200 also includes curing the adhesive to adhere the fused silica cover to the Germanium-backed multijunction solar cell, at 210. For example, curing the adhesive can include performing a low-temperature adhesive curing process to cure the silicone-based adhesive 124 and adhere the fused silica cover glass 126 to the Germanium-backed multijunction solar cell 130. For example, the coupling and curing operation can be performed as part of the packaging operation described with reference to FIG. 1F. Performing the low-temperature adhesive curing process, as opposed to a high temperature adhesive curing process, reduces stresses in communicated between the Germanium-backed multijunction solar cell 130 and the fused silica cover glass 126 due to differences in thermal expansion. In other implementations, a high temperature curing operation can be used to cure the silicone-based adhesive 124 or a different type of adhesive can be used.

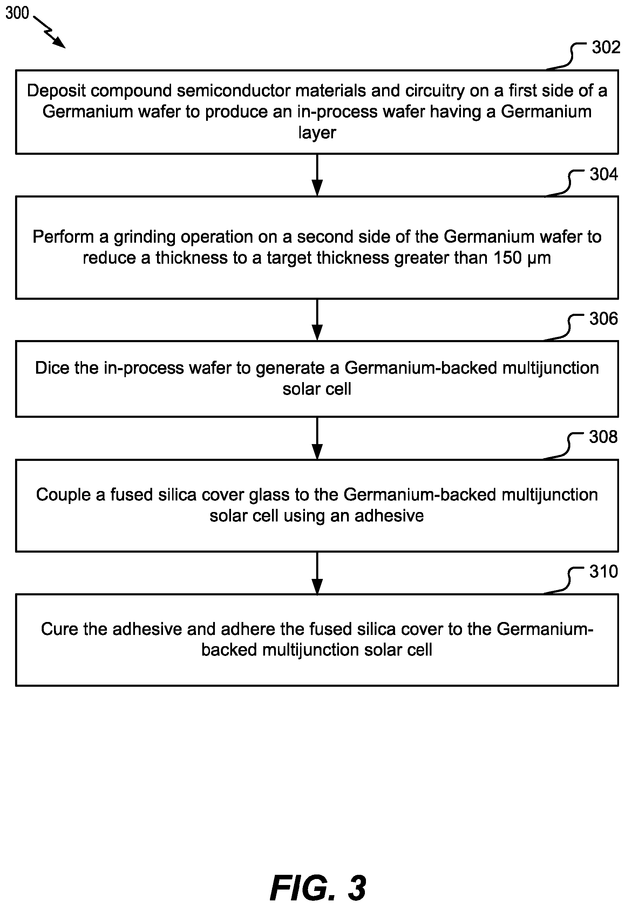

FIG. 3 is a flowchart of a second example of a method 300 of fabricating a multijunction solar cell 130 having a fused silica cover glass 126. The method 300 can be performed using the techniques described with respect to FIGS. 1A-1D and 1F.

The method 300 includes depositing compound semiconductor materials 108 and circuitry 110 on a first side 104 of a Germanium wafer 102 to produce (e.g. to form) an in-process wafer 105 having a Germanium layer 103, at 302. For example, depositing the compound semiconductor materials 108 and circuitry 110 can be performed as described with reference to FIG. 1B.

The method 300 also includes performing a grinding operation on a second side 106 of the Germanium layer 103 to reduce a thickness of the Germanium layer 103, at 304. In this context, the second side 106 of the Germanium layer 103 is opposite the first side 104 of the Germanium wafer 102. The grinding operation thins the Germanium layer 103 to a target thickness greater than 150 µm or even greater than 200 µm, such as approximately 205 µm. For example, the grinding operation can be performed as described with reference to FIG. 1C. Leaving the Germanium layer 103 with thickness greater than 150 µm increases the strength of each solar cell formed from the Germanium layer 103 as compared to solar cells formed using thinner Germanium layers (e.g., solar cells formed on substrates with thicknesses of about 140 µm or less).

The method 300 further includes dicing the in-process wafer 105 (including the Germanium layer 103) to generate (e.g., to produce or form) a Germanium-backed multijunction solar cell 130, at 306.

The method 300 also includes coupling a fused silica cover glass 126 to the Germanium-backed multijunction solar cell 130 using an adhesive, at 308. The method 300 also includes curing the adhesive to adhere the fused silica cover glass 126 to the Germanium-backed multijunction solar cell 130, at 310.

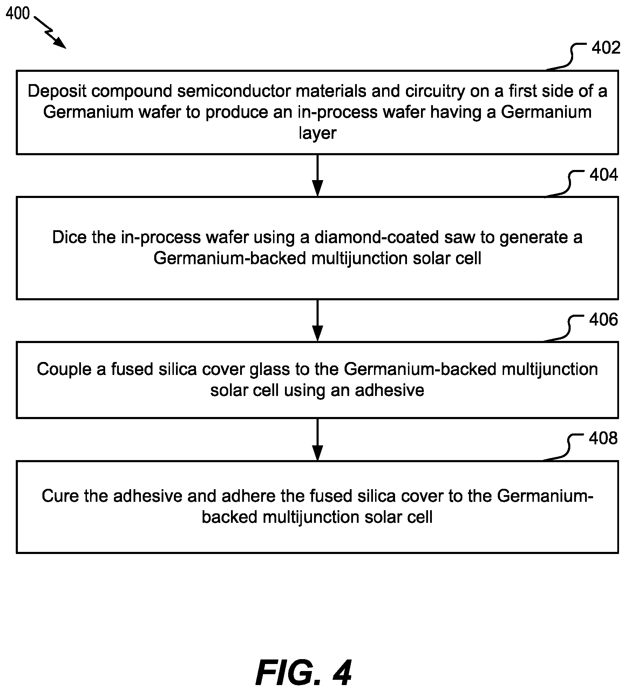

FIG. 4 is a flowchart of a third example of a method 400 of fabricating a multijunction solar cell 130 having a fused silica cover glass 126. The method 400 can be performed using the techniques described with respect to FIGS. 1A-1E.

The method 400 includes depositing compound semiconductor materials 108 and circuitry 110 on a first side 104 of a Germanium wafer 102 to produce (e.g. to form) an in-process wafer 105 having a Germanium layer 103, at 402. For example, depositing the compound semiconductor materials 108 and circuitry 110 can be performed as described with reference to FIG. 1B.

The method 400 further includes dicing the in-process wafer 105 (including the Germanium layer 103) to generate (e.g. to form or produce) a Germanium-backed multijunction solar cell 130, at 404.

The method 400 also includes coupling a fused silica cover glass 126 to the Germanium-backed multijunction solar cell 130 using an adhesive, at 406 and curing the adhesive to adhere the fused silica cover glass 126 to the Germanium-backed multijunction solar cell 130, at 408. For example, the curing operation can be performed at a relatively high temperature, such as greater than 100 deg. C, or at a relatively low temperature, such as less than 100 deg. C.

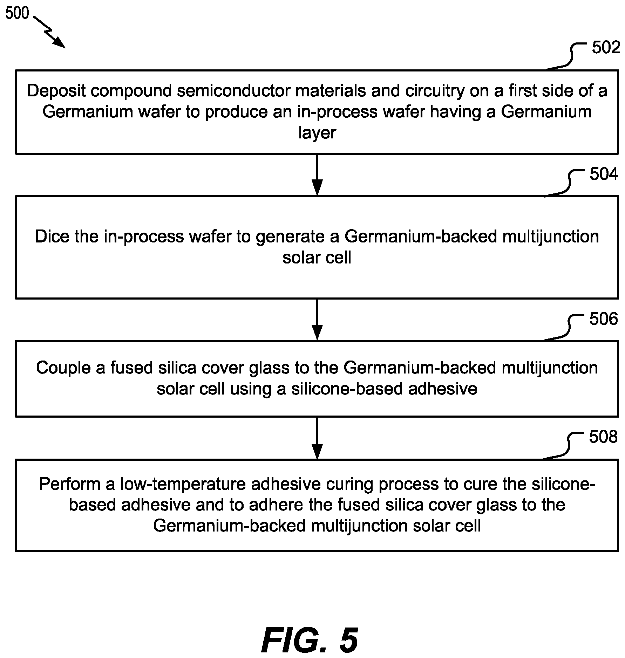

FIG. 5 is a flowchart of a fourth example of a method 500 of fabricating a multijunction solar cell 130 having a fused silica cover glass 126. The method 500 can be performed using the techniques described with respect to FIGS. 1A, 1B, 1E and 1F.

The method 500 includes depositing compound semiconductor materials 108 and circuitry 110 on a first side 104 of a Germanium wafer 102 to produce (e.g. to form) an in-process wafer 105 having a Germanium layer 103, at 502. For example, depositing the compound semiconductor materials 108 and circuitry 110 can be performed as described with reference to FIG. 1B.

The method 500 further includes dicing the in-process wafer 105 (including the Germanium layer 103) to generate a Germanium-backed multijunction solar cell 130, at 504.

The method 500 also includes coupling a fused silica cover glass 126 to the Germanium-backed multijunction solar cell 130 using a silicone-based adhesive 124, at 506. The method 500 also includes performing a low-temperature adhesive curing process to cure the silicone-based adhesive 124 and adhere the fused silica cover glass 126 to the Germanium-backed multijunction solar cell 130, at 508. For example, the coupling and curing operation can be performed as part of the packaging operation described with reference to FIG. 1F. Performing the low-temperature adhesive curing process, as opposed to a high temperature adhesive curing process, reduces stresses communicated between the Germanium-backed multijunction solar cell 130 and the fused silica cover glass 126 due to differences in thermal expansion.

The illustrations of the examples described herein are intended to provide a general understanding of the structure of the various implementations. The illustrations are not intended to serve as a complete description of all of the elements and features of apparatus and systems that utilize the structures or methods described herein. Many other implementations may be apparent to those of skill in the art upon reviewing the disclosure. Other implementations may be utilized and derived from the disclosure, such that structural and logical substitutions and changes may be made without departing from the scope of the appended claims. Accordingly, the disclosure and the figures are to be regarded as illustrative rather than restrictive.

Moreover, although specific examples have been illustrated and described herein, it should be appreciated that any subsequent arrangement designed to achieve the same or similar results may be substituted for the specific implementations shown. This disclosure is intended to cover any and all subsequent adaptations or variations of various implementations. Combinations of the above implementations, and other implementations not specifically described herein, will be apparent to those of skill in the art upon reviewing the description.

The Abstract of the Disclosure is submitted with the understanding that it will not be used to interpret or limit the scope or meaning of the claims. In addition, in the foregoing Detailed Description, various features may be grouped together or described in a single implementation for the purpose of streamlining the disclosure. Examples described above illustrate but do not limit the disclosure. It should also be understood that numerous modifications and variations are possible without departing from the scope of the appended claims. As the following claims reflect, the claimed subject matter may be directed to less than all of the features of any of the disclosed examples. Accordingly, the scope of the disclosure is defined by the following claims.

## Claims

1. A method (200) of fabricating a solar cell, the method comprising in this order:
a) depositing (202) materials to form a multijunction solar cell (130) on a first side (104) of a Germanium wafer (102) to produce an in-process wafer (105) having a Germanium layer (103);
b) performing (204) grinding and etching operations on a second side (106) of the Germanium wafer to reduce a surface roughness of the Germanium layer (103), the second side (106) of the Germanium wafer is opposite the first side (104) of the Germanium wafer (102);
c) dicing (206) the in-process wafer (105) to generate a Germanium-backed multijunction solar cell (130), wherein the dicing includes cutting the in-process wafer including the Germanium layer using a diamond-coated saw;
d) coupling (208) a fused silica cover glass (126) to the generated Germanium-backed multijunction solar cell (130) using an adhesive (124); and
e) curing (210) the adhesive (124) to adhere the fused silica cover glass (126) to the Germanium-backed multijunction solar cell (130).

2. The method (200) of claim 1, wherein the grinding operation includes one of:
reducing a thickness of the Germanium layer (103) to a thickness greater than 150 micrometers;
reducing a thickness of the Germanium layer (103) to a thickness greater than 200 micrometers;
reducing a thickness of the Germanium layer (103) to a thickness greater than 150 micrometers, the adhesive includes a silicone-based adhesive, and the curing is a low-temperature adhesive curing process performed at less than 100 degrees Celsius; and
reducing a thickness of the Germanium layer (103) to a thickness greater than 150 micrometers, the dicing includes cutting the Germanium layer (103) using a diamond-coated saw (120), the adhesive includes a silicone-based adhesive, and the curing is a low-temperature adhesive curing process performed at less than 100 degrees Celsius.

3. The method (200) of claim 1, wherein the adhesive includes a silicone-based adhesive.

4. The method (200) of claim 1, wherein the curing is a low-temperature adhesive curing process performed at less than 100 degrees Celsius.

5. The method (200) of claim 1, wherein the adhesive includes a silicone-based adhesive, and the curing is a low-temperature adhesive curing process performed at less than 100 degrees Celsius.

6. The method (200) of claim 1, comprising forming a back electrode (128) using another deposition operation performed on the in-process wafer (105) before performing the dicing operation.

7. The method (200) of claim 1, further comprising forming a back electrode (128) using another deposition operation performed on individual die cut from the in-process wafer (105) after the dicing operation.

8. The method (200) of claim 1, wherein the grinding operation reduces the thickness of the Germanium layer (103) to a thickness greater than 200 micrometers.

9. The method (200) of claim 1, wherein the grinding operation reduces the thickness of the Germanium layer (103) to a thickness greater than 150 micrometers.

10. The method (200) of claim 1, wherein the grinding operation reduces the thickness of the Germanium layer (103) to a thickness less than 150 micrometers.

11. The method (200) of claim 1, wherein the depositing materials operation include a deposition of compound of semiconductor materials (108) and a related circuitry (110) on the first side (104) of the Germanium wafer.

12. The method (200) of claim 11, wherein the compound semiconductor materials (108) are deposited using metal organic vapor phase epitaxy, MOVPE, physical vapor deposition, PVD, chemical vapor deposition, CVD, plasma-enhanced, PECVD, atomic layer deposition, ALD, evaporation, sputtering, molecular-beam epitaxy, MBE, or combinations thereof.

13. The method (200) of claim 11 or 12, wherein the related circuitry is deposited using an electrochemical deposition process or a metal organic vapor phase epitaxy, MOVPE, physical vapor deposition, PVD, chemical vapor deposition, CVD, plasma-enhanced, PECVD, atomic layer deposition, ALD, evaporation, sputtering, molecular-beam epitaxy, MBE.

14. The method (200) of claim 11, wherein additional materials are deposited on the Germanium layer (103) or the compound semiconductor materials (108) during depositing materials to form a multijunction solar cell.

15. The method (200) of claim 14, wherein the additional materials are comprised of oxide layers or nitride layers.

## Patentansprüche

1. Verfahren (200) zum Herstellen einer Solarzelle, wobei das Verfahren in dieser Reihenfolge Folgendes umfasst:
a) Abscheiden (202) von Materialien, um eine Multispektralsolarzelle (130) auf einer ersten Seite (104) eines Germaniumwafers (102) zu bilden, um einen Halbfertigwafer (105) zu produzieren, der eine Germaniumschicht (103) aufweist;
b) Durchführen (204) von Schleif- und Ätzvorgängen auf einer zweiten Seite (106) des Germaniumwafers, um eine Oberflächenrauheit der Germaniumschicht (103) zu verringern; wobei die zweite Seite (106) des Germaniumwafers entgegengesetzt zu der ersten Seite (104) des Germaniumwafers (102) ist,
c) Vereinzeln (206) des Halbfertigwafers (105), um eine germaniumgestützte Multispektralsolarzelle (130) zu erzeugen, wobei das Vereinzeln das Schneiden des Halbfertigwafers einschließlich der Germaniumschicht unter Verwendung einer diamantbeschichteten Säge umfasst;
d) Koppeln (208) eines Quarzglas-Deckglases (126) an die erzeugte germaniumgestützte Multispektralsolarzelle (130) unter Verwendung eines Klebstoffs (124) und
e) Aushärten (210) des Klebstoffs (124), um das Quarzglas-Deckglas (126) an die germaniumgestützte Mehrfachsolarzelle (130) zu kleben.

2. Verfahren (200) nach Anspruch 1, wobei der Schleifvorgang eines von Folgendem einschließt:
Verringern einer Dicke der Germaniumschicht (103) auf eine Dicke von mehr als 150 Mikrometer;
Verringern einer Dicke der Germaniumschicht (103) auf eine Dicke von mehr als 200 Mikrometer;
Verringern einer Dicke der Germaniumschicht (103) auf eine Dicke von mehr als 150 Mikrometer, wobei der Klebstoff einen Klebstoff auf Silikonbasis einschließt und das Aushärten ein Niedertemperatur-Klebstoffaushärtungsprozess ist, der bei weniger als 100 Grad Celsius durchgeführt wird; und
Verringern einer Dicke der Germaniumschicht (103) auf eine Dicke von mehr als 150 Mikrometer, wobei das Vereinzeln das Schneiden der Germaniumschicht (103) unter Verwendung einer diamantbeschichteten Säge (120) einschließt, der Klebstoff einen Klebstoff auf Silikonbasis einschließt und das Aushärten ein Niedertemperatur-Klebstoffaushärtungsprozess ist, der bei weniger als 100 Grad Celsius durchgeführt wird.

3. Verfahren (200) nach Anspruch 1, wobei der Klebstoff einen Klebstoff auf Silikonbasis einschließt.

4. Verfahren (200) nach Anspruch 1, wobei das Aushärten ein Niedertemperatur-Klebstoffaushärtungsprozess ist, der bei weniger als 100 Grad Celsius durchgeführt wird.

5. Verfahren (200) nach Anspruch 1, wobei der Klebstoff einen Klebstoff auf Silikonbasis einschließt und das Aushärten ein Niedertemperatur-Klebstoffaushärtungsprozess ist, der bei weniger als 100 Grad Celsius durchgeführt wird.

6. Verfahren (200) nach Anspruch 1, umfassend das Bilden einer Rückelektrode (128) unter Verwendung eines weiteren Abscheidungsvorgangs, der auf dem Halbfertigwafer (105) vor dem Durchführen des Vereinzelungsvorgangs durchgeführt wird.

7. Verfahren (200) nach Anspruch 1, weiter umfassend das Bilden einer Rückelektrode (128) unter Verwendung eines weiteren Abscheidungsvorgangs, der an einem einzelnen von dem Halbfertigwafer (105) nach dem Vereinzelungsvorgang geschnittenen Chip durchgeführt wird.

8. Verfahren (200) nach Anspruch 1, wobei der Schleifvorgang die Dicke der Germaniumschicht (103) auf eine Dicke von mehr als 200 Mikrometer verringert.

9. Verfahren (200) nach Anspruch 1, wobei der Schleifvorgang die Dicke der Germaniumschicht (103) auf eine Dicke von mehr als 150 Mikrometer verringert.

10. Verfahren (200) nach Anspruch 1, wobei der Schleifvorgang die Dicke der Germaniumschicht (103) auf eine Dicke von weniger als 150 Mikrometer verringert.

11. Verfahren (200) nach Anspruch 1, wobei der Materialabscheidungsvorgang ein Abscheiden einer Verbindung aus Halbleitermaterialien (108) und einer zugehörigen Schaltung (110) auf der ersten Seite (104) des Germaniumwafers einschließt.

12. Verfahren (200) nach Anspruch 11, wobei die Verbindungshalbleitermaterialien (108) unter Verwendung metallorganischer Gasphasenepitaxie, MOVPE, physikalischer Gasphasenabscheidung, PVD, chemischer Gasphasenabscheidung, CVD, plasmaunterstützter Gasphasenabscheidung, PECVD, Atomlagenabscheidung, ALD, Verdampfung, Sputtern, Molekularstrahlepitaxie, MBE, oder Kombinationen davon abgeschieden werden.

13. Verfahren (200) nach Anspruch 11 oder 12, wobei die zugehörige Schaltung unter Verwendung eines elektrochemischen Abscheidungsprozesses oder einer metallorganischen Gasphasenepitaxie, MOVPE, physikalischen Gasphasenabscheidung, PVD, chemischen Gasphasenabscheidung, CVD, plasmaunterstützten Gasphasenabscheidung, PECVD, Atomlagenabscheidung, ALD, Verdampfung, Sputtern, Molekularstrahlepitaxie, MBE, abgeschieden wird.

14. Verfahren (200) nach Anspruch 11, wobei während des Abscheidens von Materialien zusätzliche Materialien auf der Germaniumschicht (103) oder den Verbindungshalbleitermaterialien (108) abgeschieden werden, um eine Multispektralsolarzelle zu bilden.

15. Verfahren (200) nach Anspruch 14, wobei die zusätzlichen Materialien aus Oxidschichten oder Nitridschichten bestehen.

## Revendications

1. Procédé (200) de fabrication d'une cellule solaire, le procédé comprenant, dans cet ordre :
a) le dépôt (202) de matériaux pour former une cellule solaire multi-jonctions (130) sur une première face (104) d'une plaquette de germanium (102) pour produire une plaquette en cours de traitement (105) présentant une couche de germanium (103) ;
b) la réalisation (204) des opérations de meulage et de gravure sur une seconde face (106) de la plaquette de germanium pour réduire une rugosité de surface de la couche de germanium (103), la seconde face (106) de la plaquette de germanium est opposée à la première face (104) de la plaquette de germanium (102) ;
c) la découpe (206) de la plaquette en cours de traitement (105) pour générer une cellule solaire multi-jonctions à support germanium (130), dans lequel la découpe inclut la découpe de la plaquette en cours de traitement, incluant la couche de germanium, à l'aide d'une scie avec un revêtement en diamant ;
d) le couplage (208) d'un verre de couverture en silice fondue (126) à la cellule solaire multi-jonctions à support germanium générée (130) à l'aide d'un adhésif (124) ; et
e) le durcissement (210) de l'adhésif (124) pour coller le verre de couverture en silice fondue (126) à la cellule solaire multi-jonctions à support germanium (130).

2. Procédé (200) selon la revendication 1, dans lequel l'opération de meulage inclut l'une parmi :
la réduction de l'épaisseur de la couche de germanium (103) à une épaisseur supérieure à 150 micromètres ;
la réduction de l'épaisseur de la couche de germanium (103) à une épaisseur supérieure à 200 micromètres ;
la réduction de l'épaisseur de la couche de germanium (103) à une épaisseur supérieure à 150 micromètres, l'adhésif inclut un adhésif à base de silicone, et le durcissement est un processus de durcissement d'adhésif à basse température effectué à moins de 100 degrés Celsius ; et
la réduction de l'épaisseur de la couche de germanium (103) à une épaisseur supérieure à 150 micromètres, la découpe inclut le découpage de la couche de germanium (103) à l'aide d'une scie avec un revêtement en diamant (120), l'adhésif inclut un adhésif à base de silicone et le durcissement est un processus de durcissement d'adhésif à basse température effectué à moins de 100 degrés Celsius.

3. Procédé (200) selon la revendication 1, dans lequel l'adhésif inclut un adhésif à base de silicone.

4. Procédé (200) selon la revendication 1, dans lequel le durcissement est un processus de durcissement d'adhésif à basse température effectué à moins de 100 degrés Celsius.

5. Procédé (200) selon la revendication 1, dans lequel l'adhésif inclut un adhésif à base de silicone et le durcissement est un processus de durcissement d'adhésif à basse température effectué à moins de 100 degrés Celsius.

6. Procédé (200) selon la revendication 1, comprenant la formation d'une électrode arrière (128) à l'aide d'une autre opération de dépôt effectuée sur la plaquette en cours de traitement (105) avant d'effectuer l'opération de découpe.

7. Procédé (200) selon la revendication 1, comprenant en outre la formation d'une électrode arrière (128) à l'aide d'une autre opération de dépôt effectuée sur une découpe individuelle de la plaquette en cours de traitement (105) après l'opération de découpe.

8. Procédé (200) selon la revendication 1, dans lequel l'opération de meulage réduit l'épaisseur de la couche de germanium (103) à une épaisseur supérieure à 200 micromètres.

9. Procédé (200) selon la revendication 1, dans lequel l'opération de meulage réduit l'épaisseur de la couche de germanium (103) à une épaisseur supérieure à 150 micromètres.

10. Procédé (200) selon la revendication 1, dans lequel l'opération de meulage réduit l'épaisseur de la couche de germanium (103) à une épaisseur inférieure à 150 micromètres.

11. Procédé (200) selon la revendication 1, dans lequel l'opération de dépôt de matériaux inclut un dépôt de composé de matériaux semi-conducteurs (108) et un circuit associé (110) sur la première face (104) de la plaquette de germanium.

12. Procédé (200) selon la revendication 11, dans lequel les matériaux semi-conducteurs composés (108) sont déposés par épitaxie en phase vapeur aux organométalliques, MOVPE, dépôt physique en phase vapeur, PVD, dépôt chimique en phase vapeur, CVD, assisté par plasma, PECVD, dépôt de couches atomiques, ALD, évaporation, pulvérisation, épitaxie par jets moléculaires, MBE, ou des combinaisons de ceux-ci.

13. Procédé (200) selon la revendication 11 ou 12, dans lequel le circuit associé est déposé à l'aide d'un procédé de dépôt électrochimique ou d'une épitaxie en phase vapeur aux organométalliques, MOVPE, dépôt physique en phase vapeur, PVD, dépôt chimique en phase vapeur, CVD, assisté par plasma, PECVD, dépôt de couches atomiques, ALD, évaporation, pulvérisation, épitaxie par jets moléculaires, MBE.

14. Procédé (200) selon la revendication 11, dans lequel des matériaux supplémentaires sont déposés sur la couche de germanium (103) ou sur les composés de matériaux semi-conducteurs (108) lors du dépôt de matériaux pour former une cellule solaire multi-jonctions.

15. Procédé (200) selon la revendication 14, dans lequel les matériaux supplémentaires sont composés de couches d'oxyde ou de couches de nitrure.
